**Europäisches Patentamt**

**European Patent Office**

**Office européen des brevets**

(19)

(11) Veröffentlichungsnummer: **0 117 258**
**B1**

(12) ## EUROPÄISCHE PATENTSCHRIFT

(45) Veröffentlichungstag der Patentschrift:
20.05.87

(51) Int. Cl.⁴: **H 05 K 3/00**, G 03 F 7/26

(21) Anmeldenummer: **83101752.0**

(22) Anmeldetag: **23.02.83**

(54) Verfahren zur Herstellung von haftfesten Metallschichten auf Kunststoffsubstraten.

(43) Veröffentlichungstag der Anmeldung:
05.09.84 Patentblatt 84/36

(45) Bekanntmachung des Hinweises auf die Patenterteilung:
20.05.87 Patentblatt 87/21

(84) Benannte Vertragsstaaten:
DE FR GB

(56) Entgegenhaltungen:
DE-A-3 015 034
US-A-3 733 258

(73) Patentinhaber: **IBM DEUTSCHLAND GMBH,
Pascalstrasse 100, D-7000 Stuttgart 80 (DE)**
(84) Benannte Vertragsstaaten: **DE**

(73) Patentinhaber: **International Business Machines
Corporation, Old Orchard Road, Armonk, N.Y.
10504 (US)**
(84) Benannte Vertragsstaaten: **FR GB**

(72) Erfinder: **Greschner, Johann, Dr. Dipl.- Phys.,
Tiergartenweg 14, D-7401 Pliezhausen (DE)**
Erfinder: **Schwerdt, Friedrich, Nelkenstrasse 23,
D-7033 Herrenberg 1 (DE)**
Erfinder: **Trumpp, Hans- Joachim, Dr. Dipl.- Phys.,
Reichenberger Strasse 32, D-7000 Stuttgart 80 (DE)**

(74) Vertreter: **Kreidler, Eva- Maria, Dr. rer. nat.,
Schönaicher Strasse 220, D-7030 Böblingen (DE)**

## Beschreibung

Die Erfindung betrifft ein Verfahren zum Herstellen von haftfesten Metallschichten auf Kunststoffsubstraten durch Strukturieren der zu beschichtenden Substratoberflächen vor dem Metallisieren. Die Erfindung betrifft insbesondere ein Verfahren zum Herstellen von metallischen Leiterbahnen auf Epoxidharzsubstraten. Ein weiterer Aspekt der Erfindung betrifft die Anwendung des Verfahrens zur Herstellung von gedruckten Schaltungen.

Schaltkarten mit gedruckten Leiterzügen wurden traditionell hergestellt unter Anwendung eines subtraktiven Verfahrens, bei dem eine Kupferfolie auf ein geeignetes Substrat auflaminiert wird, ein Photoresist auf die Kupferfolie aufgebracht, belichtet und entwickelt wird, um das gewünschte Muster der Leiterzüge durch Abätzen des unerwünschten Kupfers von der Oberfläche der Schaltkarte zu erzeugen. Mit diesem Verfahren können Kupferleiterzüge hergestellt werden, deren Breite größer ist als die Dicke des auf die Schaltkarte auflaminierten Kupfermaterials. Bei Dichterwerden der Muster auf der Schaltkarte, bzw. bei abnehmender Breite der Leiterzüge, kann das subtraktive Verfahren wegen der seitlichen Unterätzung der Photoresistmasken nicht mehr angewendet werden. Mit dem Aufkommen zunehmender Bedürfnisse für die Herstellung dünner Leiterzüge wurden eine Reihe additiver Metallabscheidungsverfahren entwickelt, bei denen eine sehr viel dünnere Kupferfolie auf die Kunststoffsubstrate auflaminiert wird, die dann aber nicht abgeätzt wird, sondern auf der nach Aufbringen einer Photoresistmaskenschicht in den nicht abgedeckten Bereichen Leiterzüge durch stromlose Metallabscheidung aufwachsen. Das überschüssige Kupfer der auflaminierten Folie wird wieder abgeätzt. Das Hauptproblem bei diesem additiven Verfahren besteht darin, eine feste, zuverlässige Bindung zwischen den stromlos abgeschiedenen Leiterzügen und dem Substrat der Schaltkarte herzustellen.

Es sind verschiedene Verfahren bekannt, um die Haftfestigkeit der stromlos abgeschiedenen Leiterzüge oder Metallschichten auf dem Substrat zu erhöhen. Dies geschieht vor allem durch Aufrauhen der zu beschichtenden Oberfläche mittels Schleifvorgängen, Einpressen eines Reliefs in die Oberfläche, Anquellen und Aufrauhen der Oberfläche mittels Säuren, Laugen oder Lösungsmitteln, Verwendung von haftvermittelnden Zwischenschichten, Einbetten von mittels Säuren oder Laugen herauslösbarer Fremdstoffe in den Haftvermittler oder durch Aufdampfen von haftvermittelnden Zwischenschichten. So ist beispielsweise aus der deutschen Offenlegungsschrift 24 45 803 bekannt, die gesamte Oberfläche einer Trägerplatte nach dem Bohren der Löcher für die Durchkontaktierungen durch intensives, auch mehrmaliges Naßsandstrahlen vorzubereiten, um nach der Trocknung und ohne weitere Vorbehandlung die gewünschten metallischen Schichten auf der Trägerplatte abzuscheiden.

Aus der deutschen Offenlegungsschrift 24 25 223 ist ein Verfahren zum Verbessern des Haftens metallischer Schichten auf der Oberfläche eines Kunststoffsubstrats bekannt, bei dem auf eine Aluminiumfolie in einer Lösung von Zinkoxid, Kupfer-2-oxid und Natronlauge eine mikroknotige Oberfläche erzeugt wird, die Aluminiumfolie mit der mikroknotigen Oberfläche sodann auf das Kunststoffsubstrat aufgebracht wird, daß danach die Aluminiumfolie und das Zink in einem Ätzbad entfernt und sodann durch stromlose Abscheidung Leiterzüge aus Kupfer auf das so aufgerauhte Substrat aufgebracht werden.

Aus der deutschen Auslegeschrift 27 13 391 ist ein Verfahren zum Herstellen eines Trägermaterials für gedruckte Schaltungen bekannt, bei welchem das mit einer Dünnkupferschicht versehene Trägermaterial durch eines oder mehrere Walzenpaare geführt wird, wobei den Walzen oder der Oberfläche der Kupferschicht eine Aufschlämmung zugeführt wird, die Quarzmehl bzw. Glasstaub oder dgl. enthält und die Oberfläche durch Einpressen der Quarzmehl- oder Staubpartikel mikrorauh gemacht wird. Anschließend wird auf diese mikrorauhe Oberfläche eine Abdeckschicht aufgebracht, und in den nichtabgedeckten Bereichen werden durch Metallabscheidung Leiterzüge aufgebracht.

In neueren Verfahren zur Herstellung gedruckter Schaltungen wird das Kupfer durch Aufdampfen im Vakuum oder Aufsputtern auf Kunststofflaminate aufgebracht. Auch diese Verfahren sind bisher nur mit Einschränkungen zum Einsatz gekommen, weil die aufgesputterte dünne Kupferschicht relativ schlecht auf dem Kunststofflaminat haftet. Bisher bekannte Aufrauhverfahren, z.B. das Aufrauhen von Epoxidharzoberflächen in einem Sauerstoffplasma oder das in IBM Technical Disclosure Bulletin Vol. 25, Nr. 5, Oktober 1982, S. 2339 von H. Müller, J. Schneider und F. Schwerdt beschriebene Sandstrahlverfahren haben nicht zu dem gewünschten Ergebnis geführt, weil während des Aufrauhprozesses die gesamte Epoxidharzschicht dünner geätzt wird, was zu einer Beschädigung des eingebetteten Glasfasergewebes führt.

In der deutschen Offenlegungsschrift 29 16 006 ist ein Verfahren zur Herstellung von haftfesten Metallschichten auf Nichtleitern, insbesondere auf Kunststoffoberflächen beschrieben, bei dem die zu beschichtenden Oberflächenbereiche mittels eines Ätzvorgangs aufgerauht und vor dem Ätzvorgang einer energiereichen Strahlung ausgesetzt werden.

Aufgabe der Erfindung ist, ein Verfahren anzugeben, welches gestattet, durch einfache, gut kontrollierbare Prozeßschritte eine beliebige Struktur auf Kunststoffoberflächen zu erzeugen, welche die Grundvoraussetzung für nachfolgende Metallisierungsprozesse ist.

Die Aufgabe der Erfindung wird gelöst durch

2

ein Verfahren gemäß Patentanspruch 1.

Mit dem erfindungsgemäßen Verfahren können nach Größe und Form definierte Vertiefungen in der Oberfläche von Kunststoffsubstraten erzeugt werden. Mittels dieser Vertiefungen mit Überhang läßt sich die Haftfestigkeit aufmetallisierter Schichten durch eine Verzapfung mit dem Substrat weitgehend verbessern, und es können Haftfestigkeiten der Metallschicht im Bereich von etwa 1000 N/m erhalten werden.

Die erreichten Werte im Bereich von etwa 1000 N/m wurden bisher lediglich durch Anwendung von Klebersystemen oder von Haftvermittlern erreicht. Es zeigte sich jedoch, daß die mit den Haftvermittlern und Klebersystemen erzielten Haftfestigkeiten bei der späteren Verarbeitung der Materialien, insbesondere bei thermischer Beanspruchung, oft nicht ausreichend waren. Auch stören Kleber beispielsweise bei späteren Lötprozessen, wenn die genannten Materialien zur Herstellung gedruckter Schaltungen verwendet werden. Außerdem sind Kleber und Haftvermittler teuer und nur mit hohem Aufwand gleichmäßig aufzutragen.

Nach dem erfindungsgemäßen Verfahren werden in der Kunststoff-Substratoberfläche vor dem Metallisieren Vertiefungen mit Überhang durch folgende Verfahrensschritte erzeugt:

Es wird eine Glasharzschicht, vorzugsweise in einer Schichtdicke von 0,2 µm auf das zu metallisierende Substrat aufgesponnen und gehärtet. Anschließend wird ein Photo- oder Elektronenstrahlresist in einer Schichtdicke im Bereich von 1,0 bis 4,0 µm auf die Glasharzschicht aufgetragen, und durch Erwärmen auf eine Temperatur von 80 bis 90° C wird ein Teil des Lösungsmittels aus dem Resist ausgetrieben. Das Aufrauhen der Resistschicht erfolgt durch reaktives Ionenätzen in einem $CF_4$-Plasma. Sekundärelektronenmikroskop-(SEM)-Aufnahmen an auf diese Weise aufgerauhtem Photoresist zeigen, daß die Rauhigkeit Strukturen aufweist, die zwischen 0,1 und 3 µm liegen und eine ausgezeichnete Mikroverzahnung erwarten lassen. Im nächsten Schritt wird diese Rauhigkeit, ebenfalls durch reaktives Ionenätzen mit einem $CF_4$-Plasma in der Weise in die Glasharzschicht übertragen, daß ein der Photoresistrauhigkeit entsprechendes Lochmuster in der Glasharzschicht entsteht. Die so erzeugte Glasharzmatrix dient als Maske für einen reaktiven Sauerstoffätzprozeß. Dieser wird in demselben Reaktor, der zuvor verwendet wurde, durchgeführt. Zunächst werden durch die Glasharzmatrix hindurch mit einem Sauerstoffplasma etwa 2 µm tiefe Vertiefungen in die Kunststoff-Substratoberfläche, beispielsweise in die Oberfläche eines Epoxidharz-Prepregs geätzt. Danach werden nach entsprechender Einstellung des Drucks des Sauerstoffplasmas diese Vertiefungen weiter vertieft und eine Überhangstruktur erzeugt. Nach dem Entfernen der Glasharzschicht wird eine dünne, etwa 0,2 bis 0,5 µm dicke Kupferschicht aufgesputtert. Nach Aufbringen einer Photoresistmaskenschicht wird auf den nicht abgedeckten Bereichen der Schicht (6) mittels Additivtechnik ein Leiterbahnenmuster (7) stromlos abgeschieden. Die Schichtdicke des stromlos abgeschiedenen Kupfers beträgt etwa 35 µm. Das überschüssige, aufgesputterte Kupfer wird nach dem Entfernen der Photoresistmaske abgeätzt. In gleicher Weise kann anstelle von Leiterbahnen auf der aufgesputterten Kupferschicht (6) auch eine Kupferschicht (7) stromlos abgeschieden werden.

Es ist auch möglich, die aufgerauhte Photoresistschicht durch Schrägbedampfung beispielsweise mit Kupfer oder Siliciumdioxid zu bedecken und diese Struktur als Maske zur Aufrauhung der Oberfläche des Kunststoffsubstrats zu verwenden. Versuche haben jedoch gezeigt, daß nach dem Verfahren gemäß der Erfindung, bei dem die Rauhigkeit der Photoresistschicht in eine Glasharzschicht übertragen und diese Struktur als Maske verwendet wird, die Größe und Form der Vertiefungen in der Oberfläche des Kunststoffsubstrats sich wesentlich genauer einstellen lassen, wodurch eine bessere Verzapfung mit dem aufgesputterten und stromlos abgeschiedenen Kupfer und damit eine höhere Haftfestigkeit der Kupferschicht erhalten werden kann.

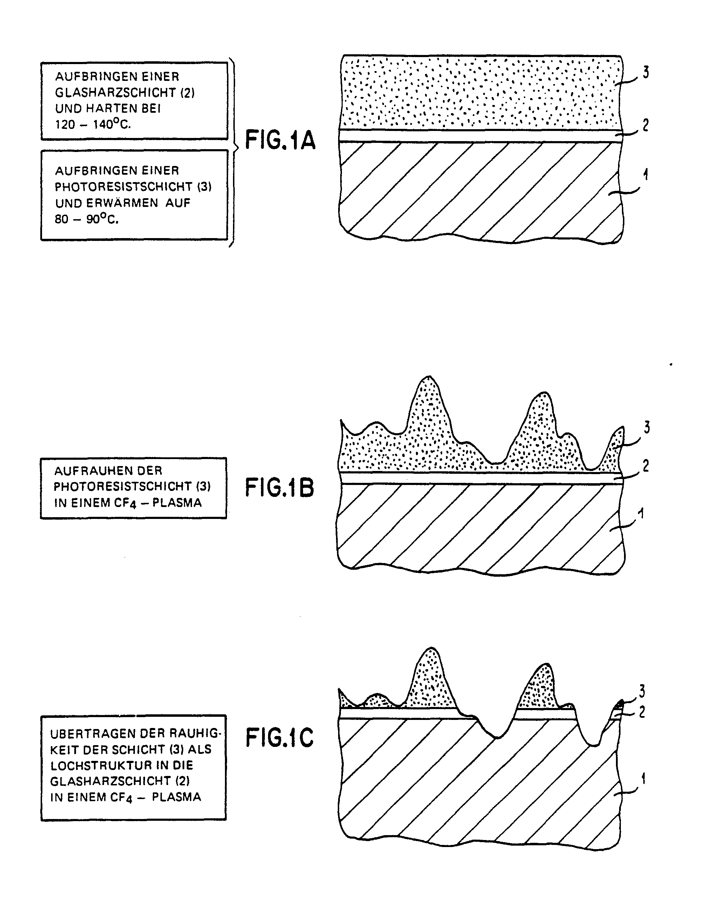

Die Erfindung wird nunmehr anhand eines Ausführungsbeispiels in Verbindung mit den Figuren 1A bis 1F, die schematische Querschnittsansichten der Struktur bei aufeinanderfolgenden Verfahrensschritten darstellen, zusammen mit einem Flußdiagramm, in dem die verschiedenen Verfahrensschritte angegeben sind, näher beschrieben.

In den Figuren 1A bis 1E ist die Übertragung der Rauhigkeit eines Photoresistmaterials in ein Substrat aus Epoxidharz mittels reaktiven Ionenätzens unter Verwendung einer Ätzbarriere aus aufgesponnenem Glasharz gezeigt. Die so strukturierte Substratoberfläche führt zu einer besonders guten Haftung von Metall auf Substrat.

Gemäß Fig. 1A wird von einem Substratmaterial ausgegangen, das hergestellt wird, indem ein Glasgewebeband zur Imprägnierung durch eine Epoxidharzlösung gezogen wird. Das kunstharzimprägnierte Glasgewebeband wird anschließend unter Anwendung von Wärme bis zu einem gewissen Grad ausgehärtet, d.h. der Epoxidharzanteil im Glasgewebe wird bis zu einem gewünschten Zustand der Teilaushärtung polymerisiert. Das solchermaßen teilausgehärtete Substratmaterial, welches als Prepreg im B-Zustand bezeichnet wird, wird dann zur Weiterverarbeitung in Platten vorgegebener Größe zerschnitten. Die Platten werden schichtweise, mit Trennfolien versehen, in einer Laminierpresse bei Temperaturen von 130 bis 180° C und Preßdrücken von 500 bis 2000 $N/cm^2$ voll ausgehärtet. Zusätzliche und spezielle Einzelheiten betreffend der Substratmaterialverarbeitung und die Zusammensetzung eines hierfür typischen Epoxidharzes lassen sich dem US-Patent 3 523 037 entnehmen.

Auf das Epoxidharz-Substratmaterial 1 wird eine Schicht 2 aus Glasharz durch Aufspinnen oder Tauchen aufgebracht. Im Ausführungsbeispiel wird das Harz auf einem Spinnteller auf die Schicht 1 aufgesponnen. Die Rotationsgeschwindigkeit beträgt dabei etwa 4200 Umdrehungen/Minute. Die Schicht 2 besteht vorzugsweise aus einer 0,2 μm dicken Schicht von Polydimethylsiloxanharz, ein Harz, das von der Firma Owens, Illinois unter der Typenbezeichnung 650 erhältlich und in N-Butylacetat aufgelöst ist, wobei auf 10 ml Lösungsmittel 1 g Harz kommt. Die Polydimethylsiloxanharzschicht 2 wird in Stickstoff bei einer Temperatur von etwa 120 bis 140° C für 10 bis 15 Minuten gehärtet. Auf die Polydimethylsiloxanharzschicht 2 wird auf einem Spinnteller eine Schicht 3 aus einem Photoresist oder einem Elektronenstrahlresist aufgesponnen. Zu diesem Zweck kann die Schicht 2 für die Aufnahme des Photoresist- oder Elektronenstrahlresistmaterials durch Hexamethyldisilazan oder das von der Firma Union Carbide Corporation erhältliche A-1100-Silan·vorbereitet werden. Die Schicht 3 kann aus beliebigen Resistmaterialien aufgebaut sein, die für Überzüge Verwendung finden und auf der Glasharzschicht 2 gut haften, thermisch stabil sind und sich durch reaktives Ionenätzen abtragen lassen. Das bevorzugte Photoresistmaterial besteht aus einem Phenolformaldehydharz und 3,4-Dihydroxybenzophenon-[4-naphthochinon(1,2)diazid(2)]-sulfonat als reaktivem Bestandteil und ist von der Firma Shipley unter der Typenbezeichnung AZ 1350J erhältlich. Der Photoresist wird in einer Schichtdicke von etwa 1,0 bis 4,0 μm aufgesponnen und etwa 20 bis 30 Minuten lang einer Temperatur von etwa 80 bis 90° C ausgesetzt. Hierbei wird ein Teil des Lösungsmittels aus dem Resist ausgetrieben.

Anschließend wird, wie in Fig. 1B gezeigt ist, die Photoresistschicht 3 durch reaktives Ionenätzen aufgerauht. Hierzu wird die Struktur der Fig. 1A in eine Kammer für eine Hochfrequenz-Zerstäubungsätzung eingebracht, wie sie beispielsweise in der US Patentschrift 3 598 710 beschrieben ist. Das Aufrauhen der Photoresistschicht 3 erfolgt durch reaktives Ionenätzen mit folgenden Parametern:

Gas: CF₄
Fluß: 30 cm³/Min.
Druck: 40 μbar
Energiedichte: 0,5 Watt/cm²
Behandlungsdauer: 5 bis 10 Minuten.

Die relativ hohe Energiedichte von 0,5 W/cm² bewirkt eine Aufrauhung bzw. Verformung des Photoresists.

Anschließend wird, wie in Fig. 1C gezeigt ist, die in der Photoresistschicht 3 erzeugte Rauhigkeit in die Glasharzschicht 2 als Lochstruktur übertragen. Die Übertragung der Rauhigkeit erfolgt durch reaktives Ionenätzen mit folgenden Parametern:

Gas: CF₄
Fluß: 30 cm³/Min.
Druck: 40 μbar
Energiedichte: 0,2 Watt/cm²
Behandlungsdauer: 15 Minuten.

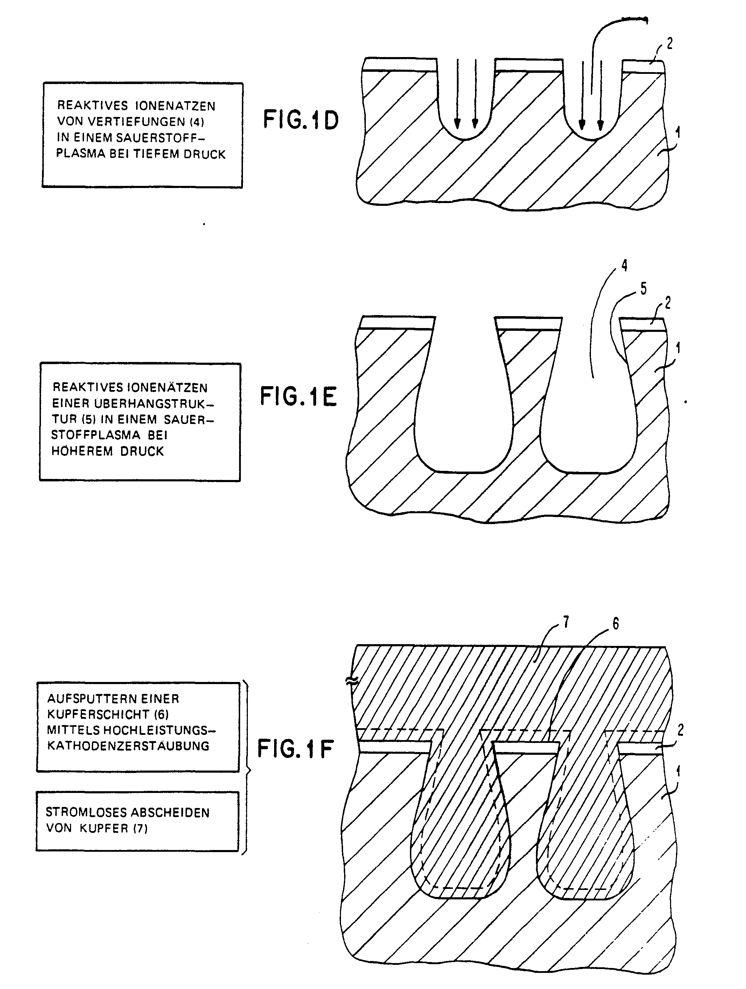

Unter Verwendung der Glasharzschicht 2 mit der Lochstruktur werden, wie in Fig. 1D gezeigt ist, in der Oberfläche des Epoxidharzsubstrats 1 durch reaktives Ionenätzen in einer Sauerstoffatmosphäre Vertiefungen 4 erzeugt. Das vertikale, reaktive Ionenätzen erfolgt mit folgenden Parametern:

Gas: O₂
Fluß: 100 cm³/Min.
Druck: 6,0 μbar
Energiedichte: 0,2 Watt/cm²
Behandlungsdauer: 10 bis 15 Minuten
Ätztiefe: 2 μm.

Das vertikale Ätzen wird durch den tiefen Druck des Sauerstoffplasmas von 4 bis 6 μbar gewährleistet.

Durch weiteres reaktives Ionenätzen in einer Sauerstoffatmosphäre können, wie in Fig. 1E gezeigt ist, die Vertiefungen des Epoxidharzsubstrats 1 weiter vertieft und eine Überhangstruktur 5 erzeugt werden. Das reaktive Ionenätzen erfolgt mit folgenden Parametern:

Gas: O₂
Fluß: 100 cm³/Min.
Druck: 250 μbar
Energiedichte: 0,2 Watt/cm²
Behandlungsdauer: 6 Minuten
Ätztiefe: etwa 4 μm.

Der Druck des Sauerstoffplasmas bestimmt die Größe des Überhangs. Wie aus Sekundärelektronenmikroskop-Aufnahmen (SEM) ersichtlich ist, kann bei einem Sauerstoffdruck von etwa 250 μbar ein klar feststellbarer Überhang erzielt werden. Die Glasharzschicht 2 kann auf dem Substrat 1 verbleiben. In diesem Fall ist sie nach dem Verkupfern mit der Oberfläche des Substrats 1 unlösbar verbunden. Sie kann aber auch, beispielsweise durch ein Trockenätzverfahren, entfernt werden.

Gemäß Fig. 1F wird auf das erfindungsgemäß strukturierte Epoxidharzsubstrat 1 mittels magnetfeldunterstützter Hochleistungskathodenzerstäubung Kupfer aufgesputtert. Diese Art der Hochleistungskathodenzerstäubung, bei der mit Hilfe eines Magnetfeldes das Plasma unmittelbar vor der Kathode konzentriert wird und die Substrate zwar dem Materialfluß des zerstäubenden Materials, aber nur zu einem geringen Teil dem Bombardement von Sekundärelektronen ausgesetzt sind, ist beispielsweise in IBM Technical Disclosure Bulletin Vol. 20, Nr. 4, September 1977, Seiten 550 bis 551 von G. R. Hunter et. al. beschrieben. Typische Hochleistungszerstäubungsraten für Kupfer liegen bei etwa 2,5 µm/Min.

Nach dem zuvor beschriebenen Verfahren wird auf die Oberfläche der Epoxidharzsubstrate 1 und der Vertiefungen 4, 5 eine etwa 0,2 bis 0,5 µm dicke Kupferschicht 6 aufgesputtert. Eine Kupferschicht 6 mit einer Schichtdicke unterhalb 0,2 µm führt nicht zu der gewünschten, besonders guten Haftung des Kupfers auf der Substratoberfläche. Die Haftwerte für die aufgesputterte Kupferschicht, die an 25 mm breiten Streifen gemessen und auf einen Meter hochgerechnet werden, liegen in einem Bereich von etwa 1000 N/m.

Anschließend werden auf der aufgesputterten Kupferschicht 6 nach Aufbringen einer Photoresistmaskenschicht (nicht dargestellt) mittels Additivtechnik Kupferleiterbahnen stromlos abgeschieden. Während die aufgesputterte Kupferschicht 6 eine Schichtdicke von etwa 0,2 bis 0,5 µm aufweist, weist das stromlos abgeschiedene Kupfer 7 eine Schichtdicke von etwa 35 µm auf. Zur Abscheidung des Kupfers kann ein Langzeitbad der Fa. Photocircuits - Kollmorgen mit folgenden Betriebsdaten verwendet werden:

ph-Wert : 12,6 eingestellt mit NaOH
$CuSO_4.5H_2O$ : 10,5 g/l hochreines Kupfersalz
HCHO (37%) : 3,5 ml/l als Reduktionsmittel
NaCN : 26 mg/l als Duktilitätsförderer
AeDTA : 17,5 g/l als Komplexierungsmittel
Temperatur : 53 ± 1°C

Die Abscheidungsrate für diesen Verfahrensschritt liegt bei etwa 2,5 µm pro Stunde. Anschließend wird die Photoresistmaskenschicht in bekannter Weise entfernt und die dünne, aufgesputterte Kupferschicht 6 in einem Durchlaufätzverfahren abgeätzt, ohne daß die Leiterzüge wesentlich angegriffen werden.

Mittels der definierten Oberflächenstruktur des Substratmaterials, die nach dem erfindungsgemäßen Verfahren erzielt wird, läßt sich die Haftfestigkeit der aufmetallisierten Schichten weitgehend verbessern. Die Größe der Vertiefungen und die Form des Überhangs läßt sich durch die speziellen aufgesponnenen Schichten aus Glasharz und Photoresistmaterial und durch die Wahl des Plasmas, den Druck und seine Anwendungsdauer einstellen. Nach dem erfindungsgemäßen Verfahren werden auf der Epoxidharzoberfläche Vertiefungen mit Überhang erzielt, die die Haftung der Metallschichten durch Verzapfung wesentlich erhöhen. Außer Epoxidharzen können auch andere Kunststoffe, beispielsweise Polyimide, vorbehandelt und anschließend metallisiert werden. Auf die erfindungsgemäß strukturierten Kunststofflaminate kann das Kupfer, wie zuvor beschrieben, aufgesputtert werden. Es kann aber auch durch Aufdampfen im Vakuum aufgebracht werden; oder es kann, nach einer Aktivierung der Substratoberfläche mit Zinn(II)chlorid-Salzsäure und Palladiumchlorid bzw. mit einem Palladiumaktivator, der organische Schutzkolloide enthält, durch reduktive Abscheidung aus einem Bad auf die strukturierte aktive Oberfläche aufgebracht werden.

In vorteilhafter Weise wird das erfindungsgemäße Verfahren zur Verkupferung von Epoxidharzfolien und Tafeln verwendet. Auf diese Weise lassen sich hochwertige gedruckte Schaltungen mit bisher unerreichten Eigenschaften bezüglich der Haftung kostengünstig herstellen.

**Patentansprüche**

1. Verfahren zum Herstellen von haftfesten Metallschichten auf Kunststoffsubstraten (1) durch Strukturieren der zu beschichtenden Substratoberflächen vor dem Metallisieren, gekennzeichnet durch folgende Verfahrensschritte:

a) Auftragen einer Glasharzschicht (2) auf das zu metallisierende Substrat (1) und Erhitzen;

b) Auftragen einer Schicht (3) aus einem Photo- oder Elektronenstrahlresist auf die Glasharzschicht (2) und Erwärmen;

c) Aufrauhen der Resistschicht (3) durch reaktives Ionenätzen in einer ersten Gasatmosphäre;

d) Übertragen der Rauhigkeit der Resistschicht (3) als Lochstruktur in die Glasharzschicht (2) durch reaktives Ionenätzen in der ersten Gasatmosphäre;

e) Herstellen von Vertiefungen (4) in der Oberfläche des zu metallisierenden Substrats (1) mittels reaktiven Ionenätzens in einer zweiten Gasatmosphäre unter Verwendung der strukturierten Glasharzschicht (2) als Maske;

f) Herstellen einer Überhangstruktur (5) in den Vertiefungen (4) durch reaktives Ionenätzen in der zweiten Gasatmosphäre;

g) Aufbringen einer dünnen Metallschicht (6) auf das nach den Schritten a) bis f) vorbereitete Substrat (1) durch Sputtern und

h) Aufbringen einer Metallschicht (7) auf die aufgesputterte Schicht (6) durch stromlose Metallabscheidung.

2. Verfahren nach Anspruch 1, dadurch gekennzeichnet,
daß die Oberfläche glasfaserverstärkter Epoxidharzsubstrate (1) strukturiert wird und auf diese durch Sputtern und stromlose Abscheidung Kupfer aufgebracht wird.

3. Verfahren nach den Ansprüchen 1 und 2, dadurch gekennzeichnet,
daß auf die strukturierte Oberfläche der Substrate (1) eine 0,2 bis 0,5 µm dicke Kupferschicht aufgesputtert wird und auf dieser 35 µm dicke Kupferleiterbahnen (7) nach Aufbringen einer Photoresistmaske mittels Additivtechnik stromlos abgeschieden werden.

4. Verfahren nach Anspruch 1, dadurch gekennzeichnet,
daß als Schicht (2) ein Polydimethylsiloxanharz in einer Schichtdicke von 0,2 µm aufgetragen und bei 120 bis 140°C für 10 bis 15 Minuten ausgehärtet wird.

5. Verfahren nach Anspruch 1, dadurch gekennzeichnet,

daß als Schicht (3) eine Photoresistschicht aus einem Phenolformaldehydharz und einem Naphthochinon-1,2-diazid-Sensibilisator in einer Schichtdicke von 1,0 bis 4,0 μm aufgetragen und auf 80 bis 90° C für 20 bis 30 Minuten erwärmt wird.

6. Verfahren nach den Ansprüchen 1, 4 und 5, dadurch gekennzeichnet,

daß die Aufrauhung der Photoresistschicht (3) und die Übertragung der Rauhigkeit als Lochstruktur in die Glasharzschicht (2) durch reaktives Ionenätzen in einem fluorhaltigen Gas durchgeführt wird.

7. Verfahren nach den Ansprüchen 1 und 6, dadurch gekennzeichnet,

daß die Aufrauhung der Photoresistschicht (3) durch reaktives Ionenätzen mit einem CF$_4$-Plasma bei einer Energiedichte von 0,5 W/cm$^2$ durchgeführt wird.

8. Verfahren nach einem oder mehreren der Ansprüche 1 bis 7, dadurch gekennzeichnet,

daß die Herstellung der Vertiefungen (4) in der Oberfläche des zu metallisierenden Substrats (1) und der Überhangstrukturen (5) durch reaktives Ionenätzen in einer sauerstoffhaltigen Gasatmosphäre durchgeführt wird.

9. Verfahren nach den Ansprüchen 1 und 8, dadurch gekennzeichnet,

daß die Vertiefungen (4) in der Substratoberfläche (1) durch vertikales reaktives Ionenätzen mit einem Sauerstoffplasma bei einem tiefen Druck von 4 bis 6 μbar hergestellt werden.

10. Verfahren nach den Ansprüchen 1 und 8, dadurch gekennzeichnet,

daß die Überhangstruktur (5) durch reaktives Ionenätzen mit einem Sauerstoffplasma bei einem Druck von 250 μbar hergestellt wird.

11. Verfahren nach den Ansprüchen 1 bis 3, dadurch gekennzeichnet,

daß auf die strukturierte Substratoberfläche Kupfer mittels magnetfeldunterstützter Hochleistungskathodenzerstäubung aufgesputtert wird.

12. Anwendung des Verfahrens gemäß den Ansprüchen 1 bis 11 zur Herstellung von gedruckten Schaltungen.

## Claims

1. Method of making adhesive metal layers on substrates of synthetic material (1) by structuring prior to metallization the substrate surfaces to be coated, characterized by the following process steps:

a) applying a glass resin layer (2) on the substrate (1) to be metallized, and heating;

b) applying a layer (3) of a photoresist or electron beam resist onto the glass resin layer (2), and heating to a moderate temperature;

c) roughening the resist layer (3) by reactive ion etching in a first gas atmosphere;

d) transferring the roughness of the resist layer (3) as a perforation structure into the glass resin layer (2) by reactive ion etching in the first gas atmosphere;

e) making recesses (4) in the surface of the substrate (1) to be metallized, by means of reactive ion etching in a second gas atmosphere, using the structured glass resin layer (2) as a mask;

f) making an overhang structure (5) in the recesses (4) by reactive ion etching in the second gas atmosphere;

g) applying a thin metal layer (6) by sputtering on the substrate (1) prepared in accordance with steps a) to f), and

h) applying a metal layer (7) on the sputtered-on layer (6) by means of electroless metal deposition.

2. Method as claimed in claim 1, characterized in that the surface of glass fiber reinforced epoxide resin substrates (1) is structured, and that copper is deposited thereon by sputtering and electroless deposition.

3. Method as claimed in any one of claims 1 and 2, characterized in that onto the structured surface of the substrate (1) a 0.2 to 0.5 μ thick copper layer is sputtered, and that on this layer 35 μm thick copper conductors (7) are applied by electroless deposition through an additive method, following the application of a photoresist mask.

4. Method as claimed in claim 1, characterized in that as a layer (2) a polydimethylsiloxane resin in a layer thickness of 0.2 μm is applied, and cured for 10 to 15 minutes at 120 to 140° C.

5. Method as claimed in claim 1, characterized in that as a layer (3) a photoresist layer consisting of a phenol-formaldehyde resin and a naphthoquinone-1,2-diazide sensitizer in a layer thickness of 1.0 to 4.0 μm is applied, and heated for 20-30 minutes to 80-90° C.

6. Method as claimed in any one of claims 1, 4 and 5, characterized in that the roughening of the photoresist layer (3) and the transfer of the roughness as a perforation structure into the glass resin layer (2) is effected by reactive ion etching in a fluorine-containing gas.

7. Method as claimed in any one of claims 1 and 6, characterized in that the roughening of the photoresist layer (3) is carried out by reactive ion etching with a CF$_4$ plasma, with an energy density of 0.5 watt/cm$^2$.

8. Method as claimed in any one or several of claims 1 to 7, characterized in that the making of the recesses (4) in the surface of the substrate (1) to be metallized, and of the overhang structures (5) is carried out by reactive ion etching in an oxygen-containing gas atmosphere.

9. Method as claimed in any one of claims 1 and 8, characterized in that the recesses (4) in the substrate surface (1) are made by vertical reactive ion etching with an oxygen plasma, at a low pressure of 4 to 6 μbar.

10. Method as claimed in any one of claims 1 and 8, characterized in that the overhang structure (5) is made by reactive ion etching with an oxygen plasma at a pressure of 250 μbar.

11. Method as claimed in any one of claims 1 to 3, characterized in that onto the structurized substrate surface copper is sputtered by means of magnetic field-supported high rate cathode sputtering.

12. Application of the method according to any one of claims 1 to 11 for making printed circuits.

**Revendications**

1. Procédé de production de couches métalliques adhérentes sur des substrats en matière plastique (1) par structuration des surfaces à revêtir du substrat avant la métallisation, caractérisé par les étapes suivantes de procédé:

a) application d'une couche de résine de verre (2) sur le substrat à métalliser (1) et chauffage,

b) application d'une couche (3) en un photorésist ou en un résist mettant en oeuvre un bombardement électronique sur la couche de résine vitreuse (2) et chauffage,

c) grainage de la couche de résist (3) par décapage ionique réactif dans une première atmosphère gazeuse,

d) transfert du grainage de la couche de résist (3) sous forme de structure à trous dans la couche de résine vitreuse (2) par décapage ionique réactif dans la première atmosphère gazeuse,

e) production de cavités (4) dans la surface du substrat à métalliser (1) au moyen d'un décapage ionique réactif dans une seconde atmosphère gazeuse et en utilisant comme masque la couche de résine vitreuse structurée (2),

f) production d'une structure en surplomb (5) dans les cavités (4) par décapage ionique réactive dans la seconde atmosphère gazeuse,

g) application par pulvérisation d'une couche métallique mince (6) sur le substrat (1) préparé selon les étapes a) à f) et

h) application d'une couche métallique (7) sur la couche appliquée par pulvérisation (6), par dépôt sans courant.

2. Procédé suivant la revendication 1, caractérisé en ce qu'on structure la surface de substrats en résine époxy renforcée de fibres de verre (1) et on applique du cuivre sur celle-ci par pulvérisation et dépôt sans courant.

3. Procédé selon les revendications 1 et 2, caractérisé en ce qu'on applique par pulvérisation sur la surface structurée des substrats (1) une couche de cuivre d'une épaisseur de 0,2 à 0,5 μm et on dépose sans courant sur celle-ci, à l'aide d'une technique additive et après application d'un masque en photorésist, des pistes conductrices en cuivre (7) d'une épaisseur de 35 μm.

4. Procédé selon la revendication 1, caractérisé en ce qu'on applique comme couche (2) une résine de polydiméthylsiloxane sous une épaisseur de couche de 0,2 μm et on la fait durcir à 120 à 140°C pendant 10 à 15 minutes.

5. Procédé selon la revendication 1, caractérisé en ce qu'on applique comme couche (3) une couche de photorésist en une résine phénol-formaldéhyde et un sensibilisateur formé de naphthoquinone-1,2-diazide, sous une épaisseur de couche de 1,0 à 4,0 μm, et on la porte à 80 à 90°C pendant 20 à 30 minutes.

6. Procédé selon les revendications 1, 4 et 5, caractérisé en ce qu'on réalise le grainage de la couche de photorésist (3) et on exécute le transfert du grainage comme structure à trous dans la couche de résine vitreuse (2) à l'aide d'un décapage ionique réactif dans un gaz contenant du fluor.

7. Procédé selon les revendications 1 et 6, caractérisé en ce qu'on réalise le grainage de la couche de photorésist (3) à l'aide d'un décapage ionique réactif avec un plasma de $CF_4$ et sous une densité d'énergie de 0,5 W/cm$^2$.

8. Procédé selon une ou plusieurs des revendications 1 à 7 caractérisé en ce que la production des cavités (4) dans la surface du substrat à métalliser (1) et des structures en surplomb (5) est réalisée à l'aide d'un décapage ionique réactif dans une atmosphère gazeuse contenant de l'oxygène.

9. Procédé selon les revendications 1 et 8, caractérisé en ce que les cavités (4) de la surface du substrat (1) sont produites à l'aide d'un décapage ionique réactif vertical avec un plasma à l'oxygène et sous une pression basse de 4 à 6 μbar.

10. Procédé selon les revendications 1 et 8, caractérisé en ce que la structure en surplomb (5) est produite à l'aide d'un décapage ionique réactif avec un plasma à l'oxygène et sous une pression de 250 μbars.

11. Procédé selon les revendications 1 à 3, caractérisé en ce qu'on applique du cuivre par pulvérisation sur la surface structurée du substrat au moyen d'une pulvérisation cathodique à haut rendement assistée par champ magnétique.

12. Application du procédé selon les revendications 1 à 11 à la fabrication de circuits imprimés.

AUFBRINGEN EINER
GLASHARZSCHICHT (2)
UND HARTEN BEI
120 – 140°C.

AUFBRINGEN EINER
PHOTORESISTSCHICHT (3)
UND ERWÄRMEN AUF
80 – 90°C.

FIG.1A

AUFRAUHEN DER
PHOTORESISTSCHICHT (3)
IN EINEM CF$_4$ – PLASMA

FIG.1B

UBERTRAGEN DER RAUHIG-
KEIT DER SCHICHT (3) ALS
LOCHSTRUKTUR IN DIE
GLASHARZSCHICHT (2)
IN EINEM CF$_4$ – PLASMA

FIG.1C

1

REAKTIVES IONENATZEN
VON VERTIEFUNGEN (4)
IN EINEM SAUERSTOFF-
PLASMA BEI TIEFEM DRUCK

**FIG.1D**

REAKTIVES IONENÄTZEN
EINER UBERHANGSTRUK-
TUR (5) IN EINEM SAUER-
STOFFPLASMA BEI
HÖHEREM DRUCK

**FIG.1E**

AUFSPUTTERN EINER
KUPFERSCHICHT (6)
MITTELS HOCHLEISTUNGS-
KATHODENZERSTAUBUNG

**FIG.1F**

STROMLOSES ABSCHEIDEN
VON KUPFER (7)